# DEMANDE DE BREVET EUROPEEN

(11) **EP 2 551 890 A1**
(43) Date de publication de la demande: **30.01.2013**
(21) Numéro de dépôt: 12177758.5
(22) Date de dépôt: 25.07.2012
(51) Int. Cl.: H01J 37/32, H01J 37/08

(54) **Installation et procédé de traitement d'un objet par un générateur de plasma**

(30) Priorité: 29.07.2011 FR 1156976
(71) Demandeur: VALEO VISION, 93012 Bobigny Cedex (FR)
(72) Inventeur: Brassier, Marc, 94170 Le Perreux (FR); Moret, Frédéric, 94100 Saint Maur Des Fosses (FR); Bretagnol, Frédéric, 63500 Issoire (FR)

(57) **Abrégé**

Cette installation (10) de traitement d'une surface d'un objet (14) comprend une chambre à vide (12), dans laquelle l'objet (14) est destiné à être placé et des moyens de traitement (32) en communication avec la chambre à vide (12) de la surface de l'objet (14) comportant des moyens de bombardement ionique comprenant un générateur de plasma (34). L'installation comprend de plus des moyens de traitement par plasma comprenant un générateur de plasma (34). Le générateur de plasma (34) est commun aux moyens de bombardement ionique et aux moyens de traitement par plasma.

L'invention concerne également un procédé de traitement d'une surface d'un objet ainsi que l'objet obtenu par ce procédé.

## Description

La présente invention concerne le domaine du traitement d'un objet, plus particulièrement du traitement de la surface de cet objet.

On connaît déjà dans l'état de la technique, notamment d'après FR-A-2 899 242, une installation de traitement d'un objet comprenant des moyens de bombardement ionique destinés à traiter au moins une surface de l'objet.

Les moyens de bombardement ionique permettent d'incorporer des ions dans une surface d'un objet, notamment pour influencer les propriétés mécaniques de cette surface (dureté, tribologie, etc.).

Les moyens de bombardement ionique comprennent classiquement, comme ceux décrits dans FR-A-2 899 242, des moyens formant générateur d'ions et des moyens formant applicateur d'ions.

L'applicateur d'ions comprend habituellement des moyens choisis par exemple parmi des lentilles électrostatiques de mise en forme de faisceau d'ions, un diaphragme, un obturateur, un collimateur, un analyseur de faisceau d'ions et un contrôleur de faisceau d'ions.

Le générateur d'ions comprend habituellement des moyens choisis par exemple parmi une chambre d'ionisation, une source d'ions à résonance cyclotronique électronique, également appelée source de plasma, un accélérateur d'ions et un séparateur d'ions.

Le bombardement ionique est habituellement réalisé sous vide. Ainsi, FR-A-2 899 242 propose de loger l'ensemble des moyens de bombardement ionique (générateur d'ions et applicateur d'ions) ainsi que les surfaces à traiter dans une chambre à vide. Des moyens de mise sous vide sont raccordés à cette chambre.

Ces moyens de mise sous vide doivent permettre d'obtenir un vide relativement poussé dans la chambre, par exemple de l'ordre de 10⁻² mbar à 10⁻⁶ mbar.

Afin d'obtenir un objet dont les propriétés répondent aux exigences techniques et esthétiques requises, notamment dans le cas d'un objet destiné à équiper un véhicule automobile, il est souvent nécessaire que l'objet subisse plusieurs traitements de surface.

Ainsi, par exemple, un masque, une platine ou un boîtier de projecteur pour véhicule automobile, ou encore un balai d'essuie-glace pouvant être réalisé en matériaux à base de polymères tels que des polymères naturels ou synthétiques, seuls ou en mélange, nécessitent divers traitements de surface avant d'être monté sur un véhicule. Ces traitements comprennent par exemple des traitements de métallisation, de rigidification de certaines parties et de dépôt d'une couche protectrice.

L'invention a notamment pour but de proposer une installation qui permet de réaliser différents traitements de surface et ce, dans une installation unique, économique et compacte.

A cet effet, l'invention a pour objet une installation de traitement d'une surface d'un objet, du type comprenant :
- une chambre à vide, dans laquelle l'objet est destiné à être placé,
- des moyens de traitement en communication avec la chambre à vide de la surface de l'objet comportant :
- des moyens de bombardement ionique comprenant un générateur de plasma, et
- des moyens de traitement par plasma comprenant un générateur de plasma,
caractérisée en ce que le générateur de plasma est commun aux moyens de bombardement ionique et aux moyens de traitement par plasma.

Par « traitement par plasma », on entend notamment l'activation par plasma de la surface de l'objet à traiter et/ou le dépôt d'un revêtement protecteur par dépôt chimique en phase vapeur assisté par plasma, appelés PECVD conformément au sigle anglais pour « Plasma Enhanced Chemical Vapor Deposition ».

On comprendra que le générateur de plasma regroupe différents éléments qui permettent de générer un plasma, que ce soit pour réaliser des traitements par plasma ou pour générer un plasma à partir duquel les ions vont être accélérés pour être ensuite implantés.

Le générateur de plasma, qui est commun aux moyens de bombardement ionique et aux moyens de traitement par plasma, permet d'obtenir une installation dans laquelle la surface d'un objet peut subir différents traitements de surface, impliquant la génération d'un plasma, sans pour autant augmenter l'encombrement de l'installation par l'utilisation de plusieurs générateurs dédiés chacun à un traitement particulier.

Le générateur de plasma commun permet également de réduire le coût d'une telle installation. En effet, un seul générateur de plasma est désormais nécessaire, là où au moins deux générateurs différents devaient être mis en place pour réaliser, par exemple, un dépôt PECVD et un traitement par bombardement ionique dans une même chambre à vide.

Suivant d'autres caractéristiques optionnelles de différents modes de réalisation de l'installation selon l'invention :
- Au moins un même générateur de plasma est apte à être utilisé indifféremment pour réaliser, en alternance, des traitements par plasma et des traitements par bombardement ionique
- Les moyens de bombardement ionique comprennent des moyens formant générateur d'ions et des moyens formant applicateur d'ions.
- L'applicateur d'ions peut comprendre des lentilles électrostatiques de mise en forme de faisceau d'ions.
- Le générateur de plasma comprend les moyens de bombardement ioniques, ces moyens de bombardement ioniques comprenant:
   - deux bornes reliées à des potentiels différents permettant de créer un plasma entre ces deux bornes,
   - une électrode extractrice permettant de sélectionner les espèces que l'on désire bombarder, et
   - au moins une électrode accélératrice disposée entre, d'une part, lesdites bornes et, d'autre part, l'objet sur la surface duquel on souhaite bombarder les ions, l'électrode accélératrice permettant d'accélérer les espèces que l'on désire bombarder.
- Le générateur de plasma peut également comprendre des moyens de mise en forme de faisceau d'ions permettant de focaliser ou faire diverger le faisceau d'ions formé par le générateur de plasma lors du bombardement ionique, ces moyens de mise en forme de faisceau d'ions pouvant être une électrode accélératrice dont la régulation de la tension permet de focaliser ou faire diverger le faisceau d'ions.
- Les moyens de traitement par plasma comprennent :
   - un élément métallique positionné dans ladite chambre à vide et relié à un potentiel de référence,
   - une desdites bornes reliée aux parois du générateur de plasma à un potentiel permettant de générer un plasma dans la chambre à vide ;
      l'installation pouvant comprendre des moyens d'injection de gaz agencés de manière à pouvoir injecter un ou plusieurs gaz directement dans ladite chambre à vide.
- Les moyens de traitement par plasma comprennent les deux bornes du générateur de plasma reliées à des potentiels différents permettant de créer un plasma entre ces deux bornes.
- La chambre à vide contient un support mobile pour y positionner chaque objet à traiter.
- Le support est monté libre en rotation dans ladite chambre à vide selon un axe de rotation.
- Le support peut se déplacer en translation parallèlement à son axe de rotation.
- Le support est amovible ; on peut ainsi facilement positionner chaque objet à traiter sur le support avant de disposer le support dans ladite chambre à vide.
- Le support est un support planétaire monté rotatif dans ladite chambre à vide autour d'un axe de rotation, ce support planétaire pouvant porter plusieurs supports satellites, notamment montés rotatifs sur le support, chacun autour d'un axe de rotation, ces axes de rotation pouvant être parallèles à l'axe de rotation du support planétaire.
- Ladite chambre à vide est susceptible d'être mise sous vide à l'aide de moyens de pompage, permettant d'atteindre un vide compris entre 10⁻¹ mbar et 10⁻⁶ mbar.
- L'installation est configurée pour que la chambre à vide, à savoir la chambre destinée à recevoir l'objet à traiter, soit mise à un vide compris entre 10⁻³ mbar et 10⁻⁴ mbar lors de la mise en oeuvre du bombardement ionique.
- Le générateur de plasma comprend une chambre d'ionisation.
- Le générateur de plasma comprend une chambre d'ionisation reliée à des moyens de pompage indépendant des moyens de pompage de la chambre à vide. Selon un mode de réalisation, l'installation, les moyens de pompage du générateur de plasma et les moyens de pompage de ladite chambre à vide sont configurés pour pouvoir placer simultanément respectivement la chambre d'ionisation du générateur de plasma à un vide compris entre 10⁻⁶ mbar et 10⁻⁷ mbar et ladite chambre à vide à un vide compris entre 10⁻³ mbar et 10⁻⁴ mbar, tout en gardant cette chambre d'ionisation du générateur de plasma en communication avec ladite chambre à vide. Ce différentiel de pression peut notamment être obtenu en jouant sur les différences de puissance entre des pompes des moyens pompage. Ce différentiel de pression est mis en oeuvre pour le bombardement ionique de l'objet à traiter.
- Le générateur de plasma comprend des moyens d'injection de gaz aptes à injecter des gaz de nature différente, seuls ou en mélange. L'installation permet ainsi de réaliser des traitements de surface différents, notamment, de réaliser un traitement d'activation de la surface en créant un plasma avec un gaz, de réaliser un dépôt d'un revêtement en surface de l'objet en créant un plasma avec un autre gaz et/ou d'implanter des ions accélérés à partir d'un plasma créé à partir d'un autre gaz. L'installation ainsi obtenue permet une grande diversité de traitements du fait que l'on peut diversifier notamment la nature des gaz utilisés, la nature des dépôts réalisés, la séquence des traitements de surface réalisés, etc. Ainsi, lors d'un traitement d'activation ou de minéralisation de surface par plasma, les gaz les plus souvent utilisés sont choisis parmi l'air, l'argon (Ar), le dioxygène (O₂), le diazote (N₂), le protoxyde d'azote (N₂O), le dioxyde de carbone (CO₂), la vapeur d'eau (H₂O_{(g)}), l'ammoniac (NH₃) ou l'iode (I₂), seuls ou en mélange. Lors d'un dépôt PECVD, les gaz sont préférentiellement choisis parmi le groupe des disiloxanes tels que l'hexaméthyldisiloxane (HMDSO) ou le tétraméthyldisiloxane (TMDSO), parmi le groupe des hydrocarbonés aliphatiques, cycloaliphatiques, aromatiques tel que le méthane (CH₄), l'éthane (C₂H₆), l'éthylène (C₂H₄), le cyclopentène (C₅H₈), parmi le groupe des dérivés azotés tel que le nitroéthane (C₂H₅NO₂), parmi le groupe des alcools primaires tel que le méthanol (CH₄O) ou l'éthanol (C₂H₆O) seuls ou en mélange. Ce traitement permet de réaliser sur la surface des objets une couche de protection très mince d'épaisseur comprise notamment entre 10 et 100 nm en matériau majoritairement ou en totalité inorganique ; lors d'un traitement par bombardement ionique, les ions utilisés pour le bombardement seront des ions issus de gaz précurseurs préférentiellement choisis parmi l'hélium (He), l'argon (Ar) ou le diazote (N), seuls ou en mélange.
- Le générateur de plasma est de petites dimensions, c'est-à-dire que sa plus grande dimension est inférieure à 10 cm. De préférence, sa plus grande dimension est inférieure à 5 cm. Le générateur de plasma de petite dimension permet de réduire l'encombrement global de l'installation. En outre, un générateur de plasma de petites dimensions permet de réduire l'énergie nécessaire à l'amorçage du plasma et à son entretien tout en garantissant un plasma d'intensité adéquate. Ces faibles puissances d'amorçage et d'entretien permettent d'utiliser des éléments de faible dimension pour l'alimentation du générateur, ce qui réduit d'autant l'encombrement du générateur et donc de l'installation. Du fait de leurs faibles dimensions, il est possible lorsqu'on place deux générateurs de ce type côte à côte d'avoir une distance réduite entre les faisceaux à leur sortie contrairement aux générateurs de plus grandes dimensions. Ceci permet d'améliorer le recouvrement des faisceaux et donc l'homogénéité du traitement.
- L'installation comprend une pluralité de générateurs de plasma. On obtient une installation qui permet de traiter un objet ayant une grande surface à traiter ou de traiter simultanément une pluralité d'objets et ce, par assemblage des générateurs en les disposant côte à côte. Avantageusement, ces générateurs sont de petites dimensions, ce qui permet un agencement plus compact des générateurs l'un par rapport à l'autre afin d'obtenir une homogénéité accrue du traitement de surface. Les générateurs de plasma peuvent être disposés côte à côte et forment une matrice, les moyens de mise en forme de faisceau d'ions permettant de faire diverger les faisceaux d'ions respectifs pour que les faisceaux d'ions de générateurs de plasma côte à côte se recouvrent. Dans ce cas, les générateurs de plasma peuvent également comprendre les moyens de mise en forme de faisceau d'ions précités, les moyens de mise en forme de faisceau d'ions permettant de faire diverger les faisceaux d'ions respectifs pour que les faisceaux d'ions des générateurs de plasma côte à côte se recouvrent.
- L'installation comprend des moyens de contrôle de chaque générateur indépendamment de toute autre générateur, ce qui permet un contrôle permanent et précis de la génération de plasma.
- Les moyens de contrôle comprennent, pour chaque générateur, des moyens d'activation/désactivation du générateur, comme par exemple un interrupteur. Ainsi, en fonction de la surface de l'objet à traiter, on peut choisir d'utiliser ou non chaque générateur.
- L'installation comprend en outre des moyens de dépôt PVD par pulvérisation cathodique sous vide ou par évaporation sous vide. Le sigle en anglais PVD (« Physical Vapor Deposition ») désigne un dépôt physique en phase vapeur qui permet de réaliser sur la surface des objets une couche métallique très mince d'épaisseur comprise notamment entre 1 et 150 nm, préférentiellement entre 10 et 100 nm. Cette couche métallique peut être par exemple de l'aluminium, de l'argent, du chrome, un alliage de nickel et de chrome, du titane, du zinc et leurs oxydes ou également un acier inoxydable (ST 304, 306, 310, 312, 321, par exemple).
- L'installation comprend des moyens d'isolement du générateur de plasma par rapport à la chambre à vide, ces moyens d'isolement comprenant, par exemple, une porte. Ainsi, lors des opérations de chargement/déchargement de la chambre à vide, les générateurs de plasma sont maintenus dans des conditions de vide appropriées. Il est également possible, lorsque l'on réalise un dépôt PVD, par exemple, de fermer cette porte pour protéger le générateur de plasma des vapeurs créées lors des procédés PVD et PECVD.

L'invention a également pour objet un procédé de traitement de surface d'un objet du type dans lequel on place l'objet à traiter dans une chambre à vide d'une installation telle que décrite précédemment.

L'invention concerne aussi un objet caractérisé en ce qu'il est traité par le procédé définit ci-avant.

L'invention sera mieux comprise à la lecture de la description qui va suivre, donnée uniquement à titre d'exemple et faite en se référant aux dessins dans lesquels :
- la figure 1 est une vue schématique en élévation d'une installation de traitement selon un premier mode de réalisation de l'invention ;
- la figure 2 est une vue schématique en coupe d'un générateur de plasma ;
- la figure 3 est une vue schématique de dessus d'une installation selon un second mode de réalisation de l'invention ;
- la figure 4 est une vue d'un agencement des générateurs de plasma selon le plan de coupe IV-IV de la figure 3.

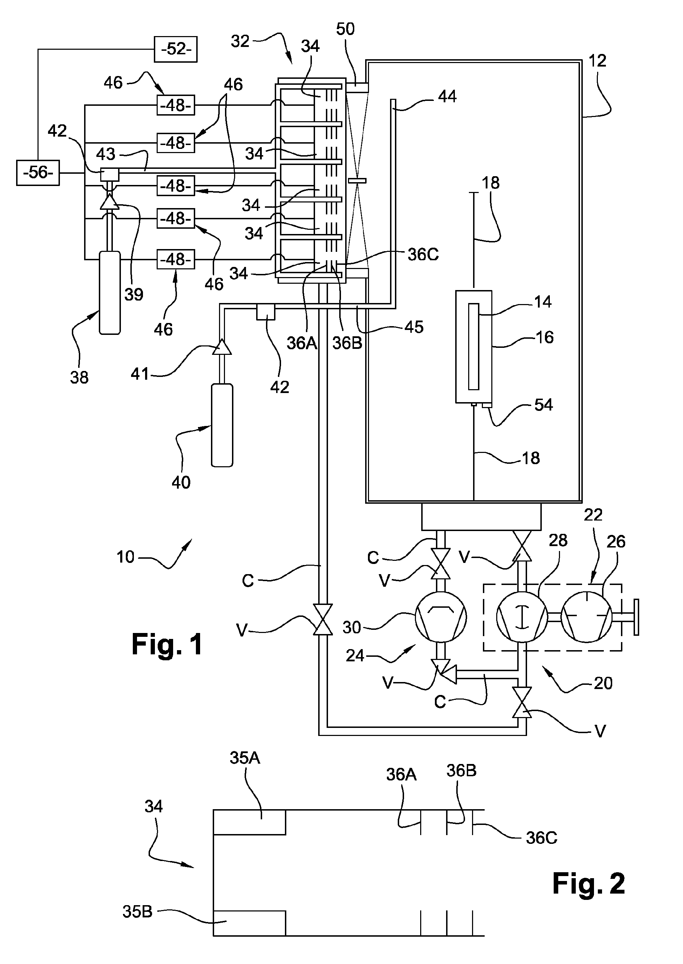

On a représenté sur la figure 1 une installation 10 de traitement d'une surface d'un objet selon un premier mode de réalisation de l'invention.

L'installation 10 est destinée notamment à traiter la surface d'un élément de projecteur ou de feux pour véhicule automobile tel qu'un masque, un enjoliveur, une platine, un boîtier, un réflecteur, un écran de projecteur ou une lame d'essuie-glace.

L'installation 10 est destinée à traiter la surface de l'objet, notamment pour y effectuer des dépôts de couches minces et/ou influencer les propriétés mécaniques et/ou optiques de la surface de l'objet.

L'installation 10 comprend une chambre à vide 12 dans laquelle au moins un objet 14 est destiné à être placé. Dans ce mode de réalisation, la chambre 12 contient un support 16 amovible, monté libre en rotation dans la chambre 12 selon un axe de rotation 18. Ce support 16 peut également se déplacer en translation parallèlement à l'axe de rotation 18. Ce support 16 étant amovible, on peut facilement positionner chaque objet à traiter sur le support 16 avant de disposer le support 16 dans la chambre 12.

Cette chambre 12 est susceptible d'être mise sous vide à l'aide de moyens de pompage 20 comprenant un ensemble de pompage primaire 22, permettant d'atteindre un vide d'environ 10⁻² mbar et, de préférence, un ensemble de pompage secondaire 24, permettant d'atteindre un vide compris entre 10⁻² mbar et 10⁻⁶ mbar.

L'ensemble de pompage primaire 22 peut, par exemple, comprendre une pompe mécanique rotative 26 montée en série avec une pompe de Roots 28. La pompe mécanique rotative 26 permet d'atteindre un vide d'environ 10⁻¹ mbar. Ce niveau de vide permet alors l'amorçage de la pompe de Roots 28. Cette dernière permet d'atteindre un vide d'environ 10⁻² mbar.

Par ailleurs, dans cet exemple, l'ensemble de pompage secondaire 24 comprend une pompe permettant d'atteindre un vide compris entre 10⁻² et 10⁻⁶ mbar environ, par exemple une pompe à diffusion 30.

Ces moyens de mise sous vide 20 sont raccordés à l'installation 10 par des conduits C et des vannes V qui permettent de raccorder, de façon sélective, selon les conditions de traitement souhaitées, les différentes parties de l'installation aux moyens de pompage 20.

L'installation 10 comprend des moyens 32 de traitement dans la chambre 12 de la surface de l'objet 14. Ces moyens de traitement 32 comprennent, dans le cas présent, cinq générateurs de plasma 34 alignés, disposés côte à côte et comportant des électrodes 36A, 36B et 36C. Ces générateurs 34 sont de petites dimensions, c'est-à-dire que leur plus grande dimension est inférieure à 10 cm.

Grâce à la petite taille des générateurs de plasma 34, en comparaison à des générateurs classiques dont la dimension la plus petite est de l'ordre de 25 cm, on peut facilement disposer les générateurs 34 côte à côte sans pour autant avoir une installation très volumineuse en permettant de rapprocher les faisceaux pour améliorer l'homogénéité du traitement.

Avantageusement, ces générateurs 34 peuvent être disposés suffisamment proches l'un de l'autre, de sorte que l'on puisse traiter de façon homogène, en utilisant plusieurs de ces générateurs, une surface d'un objet 14 placé dans la chambre 12.

Dans le mode de réalisation de la figure 1, l'installation 10 permet de traiter la surface des objets par traitement par plasma et par bombardement ionique et les générateurs 34 sont communs aux moyens de traitement par plasma et aux moyens de bombardement ionique.

L'installation 10 comprend en outre des moyens d'injection de gaz 38, 40 qui comprennent notamment des vannes 39, 41, un dispositif de contrôle de débit gazeux 42, par exemple un débitmètre massique calibré, et des conduits 43, 45 afin d'injecter le gaz choisi à l'endroit désiré avec le débit requis au traitement de surface réalisé. Les gaz injectés peuvent être injectés seuls ou en mélange.

Dans ce mode de réalisation, deux gaz différents sont injectés : le premier gaz est injecté, par les moyens d'injection 38, dans chaque générateur de plasma 34 et le second gaz est injecté dans la chambre à vide 12, par les moyens d'injection 40 qui comprennent un tube diffuseur 44 disposé dans la chambre à vide 12, entre les générateurs de plasma 34 et l'objet à traiter 14. On a représenté, dans cet exemple, des moyens d'injection 40 d'un seul gaz dans le tube diffuseur 44. On peut aisément faire en sorte que ces moyens d'injection 40 permettent d'amener plusieurs gaz de nature différente, seuls ou en mélange, dans le tube 44.

En l'occurrence, les moyens de traitement par plasma comprennent les mêmes générateurs de plasma 34 que les moyens de bombardement ionique.

En se référant à la figure 2, on va décrire un générateur de plasma 34 et son fonctionnement. Pour réaliser un traitement par bombardement ionique, il est nécessaire, après création d'un plasma entre deux bornes 35A et 35B reliées à des potentiels différents et comprises dans le générateur 34, de sélectionner les espèces que l'on désire bombarder au moyen d'une électrode extractrice 36A et de les accélérer au moyen de deux électrodes accélératrices 36B et 36C disposées entre, d'une part, les bornes 35A et 35B et, d'autre part, l'objet 14 sur la surface duquel on souhaite bombarder les ions. La borne 35A est par exemple reliée à un potentiel de référence et isolée électriquement du reste du générateur 34 et la borne 35B est reliée à un potentiel permettant de générer le plasma entre les deux bornes 35A et 35B. Selon que ces bornes sont alimentées en courant continu ou en courant alternatif, on parlera respectivement des électrodes 35A et 35B ou de des antennes 35A et 35B. Selon une réalisation de l'invention, l'électrode accélératrice 36C peut faire partie de moyens de mise en forme de faisceau d'ions permettant de focaliser ou faire diverger le faisceau d'ions formé par le générateur de plasma 34 lors du bombardement ionique. L'électrode accélératrice 36C est dans ce cas reliée à des moyens de régulation de la tension à laquelle elle est soumise. En régulant, cette tension il est possible de focaliser ou de faire diverger le faisceau d'ions.

Pour réaliser un traitement par plasma dans ce mode de réalisation de l'installation, on utilisera la borne 35B qui, reliée aux parois du générateur 34, permettra de générer un plasma dans la chambre 12, les parois métalliques de la chambre 12 constituant la borne reliée au potentiel de référence. On peut également placer dans la chambre 12 un élément métallique qui sera relié au potentiel de référence. Cet élément métallique peut remplacer ou venir en complément des parois métalliques de la chambre 12.

L'installation 10 comprend également des moyens de contrôle 46 de chaque générateur indépendamment de toute autre générateur. Ainsi, il est possible de faire varier la puissance de chaque générateur de plasma 34 indépendamment des autres générateurs 34. Il est également possible de contrôler le débit de gaz qui alimente chaque générateur 34. Lors du traitement par bombardement ionique, ces moyens de contrôle 46 peuvent également comprendre des moyens de réglage de la position du générateur et des moyens de réglage de l'angle du faisceau d'ions émis.

Les moyens de contrôle 46 de chaque générateur comprennent, en outre, des moyens d'activation/désactivation 48 du générateur 34. Ainsi, on peut choisir d'activer ou non un générateur 34 indépendamment de tout autre générateur 34. Ces moyens d'activation/désactivation 48 peuvent comprendre un interrupteur.

L'installation 10 comprend également des moyens d'isolement 50 des générateurs de plasma 34 par rapport à la chambre à vide 12. Ces moyens d'isolement comprenant par exemple une porte 50 que l'on peut fermer ou ouvrir selon que l'on désire isoler ou non les générateurs 34 de la chambre à vide 12.

Ainsi, lors des opérations de chargement/déchargement de la chambre à vide 12, on peut fermer la porte 50, si bien que les générateurs 34 peuvent rester sous vide, alors que la chambre 12 est remise à l'atmosphère.

Lors d'une nouvelle opération de traitement de surface, il suffira de recréer des conditions de vide appropriées dans la chambre 12, avant de remettre en communication cette chambre 12 avec les générateurs 34.

On arrive ainsi, lors des opérations de chargement/déchargement de la chambre à vide 12, à maintenir dans l'environnement immédiat des générateurs de plasma 34, un niveau de vide assez proche de celui souhaité dans la chambre 12 pour traiter un objet. Ceci permet d'optimiser la durée et l'énergie nécessaire pour remettre la chambre 12 et les générateurs 34 dans des conditions de vide appropriées après chaque opération de chargement/déchargement de cette chambre.

Dans ce mode de réalisation, l'installation 10 comprend aussi des moyens d'identification 52 de l'objet 14 à traiter, comme par exemple un lecteur optique apte à lire un code barre 54 d'identification de l'objet 14. Le code barre 54 est ici porté par le support 16 qui est spécifique à l'objet 14 à traiter.

Les moyens de contrôle 46 et les moyens d'identification 52 sont pilotés au moyen d'un programme d'ordinateur 56 appelé « PLC » conformément au sigle anglais pour « Program Logical Controller » ou bien au moyen d'un ordinateur industriel.

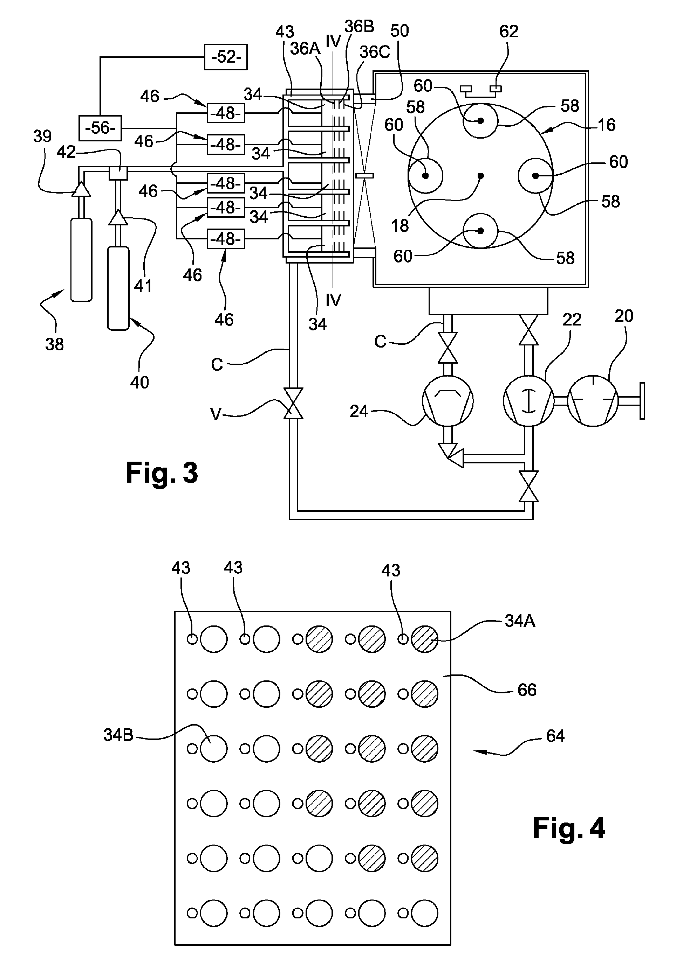

La figure 3 présente un second mode de réalisation de l'installation dans lequel les éléments communs aux deux modes de réalisation sont identifiés par les mêmes références numériques.

Dans ce mode de réalisation, le support 16 est un support planétaire monté rotatif dans la chambre 12 autour d'un axe de rotation 18. Ce support planétaire 16 porte plusieurs supports satellites 58 montés rotatifs sur le support 16 chacun autour d'un axe de rotation 60. Ces axes de rotation 60 sont, dans le cas présent, parallèles à l'axe de rotation 18 du support planétaire16. Ces supports satellites 58, dans cet exemple au nombre de quatre, sont destinés à porter chacun au moins un objet à traiter 14. Ce support planétaire 16 peut également se déplacer en translation parallèlement à l'axe de rotation 18.

On notera cependant que, dans le second mode de réalisation, les moyens d'injection 38, 40 sont agencés différemment que dans le premier mode de réalisation. En effet, dans ce second mode de réalisation, les deux gaz sont injectés dans les générateurs de plasma 34. De plus, dans ce second mode de réalisation, les deux gaz peuvent être mélangés avant leur arrivée dans le générateur.

Dans ce mode de réalisation, les gaz arrivant directement dans les générateurs de plasma, lors d'un traitement par plasma, on utilisera les bornes 35A et 35B du générateur 34 afin de créer le plasma, et non la borne 35B et les parois métalliques de la chambre 12 comme dans le mode de réalisation précédent. Avantageusement, l'installation 10, représentée sur la figure 3, comprend également des moyens 62 de dépôt PVD logés dans la chambre à vide 12. Lors d'un traitement par PVD, il est souhaitable de fermer la porte 50 afin d'isoler les générateurs de plasma 34 de la chambre à vide 12 et ainsi de les protéger de tout dépôt métallique qui pourrait, à la longue, être dommageable pour les générateurs. De plus, lors de ce type de dépôt, le niveau de vide nécessaire est différent et la fermeture de la porte 50 permet de conserver les générateurs de plasma 34 dans les conditions de vide appropriées.

On a représenté sur la figure 4 un assemblage 64 de générateurs 34 de l'installation 10 représentée sur la figure 3. Cet assemblage 64 comprend trente générateurs 34 répartis en six lignes et cinq colonnes sur un support 66 pour un traitement donné de la surface d'un ou de plusieurs objets 14 identifiés et placés dans la chambre à vide 12. Le support 66 est de forme sensiblement rectangulaire et plan. On comprend que la forme du support 66 n'est pas limitée à un rectangle. On pourrait imaginer, par exemple dans le cas d'une chambre 12 dont une paroi est cylindrique, que ce support 66 épouse la forme de la paroi de la chambre 12. Ce support 66 pourrait également prendre une forme incurvée afin de pouvoir atteindre certaines surfaces des objets 14 à traiter et ce, indépendamment de la forme de la chambre 12.

Les générateurs hachurés 34A représentent les générateurs qui sont activés au cours du traitement de surface alors que les autres générateurs 34B représentent les générateurs qui seront désactivés pour ce traitement. On constate que, dans cet exemple, on active quatorze générateurs.

Pour un autre traitement du même objet, il se peut que l'on active un nombre différent de générateurs 34 ou le même nombre de générateurs 34 mais les générateurs activés 34A étant répartis différemment.

Ainsi, les générateurs activés 34A sont déterminés pour un objet 14 donné et pour un traitement donné.

On notera que l'on a représenté un assemblage 64 de générateurs 34 disposés en ligne et en colonne. Mais on aurait pu également représenter un assemblage de générateurs disposés en quinconce.

On notera que la surface à traiter de l'objet 14 peut être différente selon le type de traitement que l'on applique à l'objet 14. Ainsi, on peut souhaiter réaliser un dépôt PVD sur une surface de l'objet 14 et réaliser du bombardement ionique sur une autre surface de l'objet 14. Ces surfaces peuvent toutefois avoir des zones communes, en tout ou en partie.

On peut également envisager d'utiliser, pour créer le plasma, des moyens connus qui permettent de transférer l'énergie générée par un quartz excité à des fréquences micro-ondes.

On notera enfin que l'invention n'est pas limitée aux modes de réalisation précédemment décrits. Ainsi, l'installation peut comprendre un unique générateur de plasma. Les supports 16 des premier et deuxième modes de réalisation sont interchangeables et non limités aux supports présentés. Le premier mode de réalisation peut également comprendre des moyens 62 de dépôt PVD logés dans la chambre à vide 12 et des générateurs disposés en matrice.

### Exemple 1 : procédé de traitement d'un ou de plusieurs objets 14

On décrira maintenant un exemple de procédé de traitement d'une surface d'un objet dans une installation telle que décrite précédemment.

On considère un objet 14 dont on souhaite traiter une surface. On détermine différents paramètres de l'objet 14 tels que la surface ou les surfaces à traiter, le type de traitement de surface à réaliser, la séquence de traitements, la géométrie de l'objet, etc. Ces paramètres permettent, pour un traitement de surface donné, notamment de déterminer chaque générateur à activer, quelle puissance utiliser pour alimenter chaque générateur, s'il faut ou non alimenter les électrodes d'extraction 36A et d'accélération d'ions 36B et 36C, quelle est la nature du gaz à utiliser, quel débit de gaz est nécessaire.

On stocke ces paramètres dans une base données, ces paramètres étant reliés dans la base de données à un identifiant de l'objet 14. Cet identifiant peut, par exemple, être un code barre 54 associé à l'objet 14. Cette base de données est hébergée sur l'ordinateur 56 sur lequel est exécuté le programme « PLC ». On peut également envisager que la base de données soit hébergée sur un autre ordinateur.

Lorsque l'objet 14 est prêt à être traité dans l'installation 10, on place l'objet 14 sur son support 16 spécifique et on identifie l'objet grâce aux moyens d'identification 52 qui permettent de lire le code barre 54 porté par le support 16 de l'objet 14. Cette identification permet d'extraire de la base de données les paramètres liés à l'objet 14 ainsi que la séquence de traitements qu'il faut lui appliquer. Les paramètres de traitement sont envoyés au programme « PLC » qui pilote les moyens de pompage 20, les moyens de contrôle 46 de chaque générateur 34 ainsi que les flux de gaz requis.

On place ensuite l'ensemble du support 16 et de l'objet 14 dans la chambre à vide 12 et on réalise les conditions de vide appropriées aux différents traitements de surface que l'on souhaite réaliser un vide d'environ 10⁻³ mbar.

Une fois que les conditions de vide appropriées sont atteintes, on ouvre la porte 50 pour mettre les générateurs 34, préalablement maintenus à un niveau de vide d'environ 10⁻⁶ mbar, en communication avec la chambre 12.

On réalise, par exemple, un traitement par bombardement ionique par un faisceau d'ions Hélium mono-chargés (He⁺). Grâce à l'identification de l'objet 14, le programme « PLC » va notamment activer sélectivement les générateurs 34 nécessaires à chaque traitement.

Par exemple, le bombardement est réalisé, d'une part, en excitant les générateurs 34A de petites dimensions à une fréquence de 2,45 GHz pour initier le plasma et, d'autre part, en les alimentant en Hélium. Le plasma ainsi créé, les ions He⁺ sont extraits au moyen de l'électrode 36A portée à un potentiel de 30 kV puis accélérés par l'électrode 36B portée à un potentiel de 25 kV et un courant de 1 mA et l'électrode 36C portée à un potentiel nul (terre) et un courant de 1 mA.

Le programme « PLC » ou l'ordinateur industriel peut en outre contrôler la vitesse de rotation du support 16 afin de contrôler le temps de traitement de chaque surface de l'objet 14. Dans le cas présent, la vitesse de rotation est définie pour correspondre à un temps de traitement de la surface de 3 secondes correspondant à une dose d'ions He⁺ reçue de 6.10¹⁵ ions/cm².

A la fin du traitement par bombardement ionique, on ferme la porte 50 et on réalise un pompage pour atteindre 10⁻⁵ mbar, conditions dans lesquelles on réalise un dépôt PVD d'une couche d'aluminium comprise entre 50 et 70 nm d'épaisseur.

Une fois la couche d'aluminium déposée, on injecte, à travers le débitmètre 42 une quantité de monomère HMDSO correspondant à un débit de 100 sccm (conformément au sigle anglais pour « standard cubic centimeter »).

Lorsque la pression est stabilisée à 5.10⁻² mbar, on ouvre la porte 50 pour mettre l'ensemble des générateurs en communication avec la chambre.

On alimente sélectivement les générateurs 34 nécessaires à ce traitement à une fréquence de 2,45 GHz pour initier le plasma HMDSO. Dans le plasma, les monomères polymérisent et se déposent sur l'objet 14, formant une couche de protection transparente de la couche d'aluminium préalablement déposée par PVD.

Dans cet exemple, l'injection de gaz et l'alimentation des générateurs 34 sont arrêtées après 60 secondes permettant d'obtenir un dépôt ayant une épaisseur comprise entre 25 et 40 nm.

On ferme ensuite la porte 50 et on remet la chambre 12 à pression atmosphérique afin d'en extraire chaque objet 14 traité.

L'installation 10 est alors disponible pour le traitement d'un ou de plusieurs nouveaux objets.

On peut également modifier les dépôts réalisés par PVD et PECVD en utilisant le bombardement ionique en même temps que le dépôt PVD ou PECVD.

On peut également envisager de réaliser ces plusieurs traitements simultanément en répartissant les générateurs 34 de l'assemblage 64 entre les différents traitements de surface que l'on souhaite réaliser.

### Exemple 2 : mélanges de gaz

Pour le bombardement ionique, on peut envisager d'utiliser des mélanges de gaz choisis parmi les mélanges He/Ar (par exemple, en ratio de débit de gaz : 80/20 ou 50/50), He/N2 (par exemple, en ratio de débit de gaz : 80/20 ou 20/80) ou He/Ar/N₂ (par exemple, en ratio de débit de gaz : 60/20/20).

Pour le traitement plasma, les mélanges suivants peuvent être utilisés : air/Ar (par exemple, en ratio de débit de gaz : 60/40), Ar/N2 (par exemple, en ratio de débit de gaz : 50/50), Ar/N₂O (par exemple, en ratio de débit de gaz : 50/50 ou 80/20), HMDSO/TMDSO (par exemple, en ratio de débit de gaz : 80/20), HMDSO/N₂O/Ar (par exemple, en ratio de débit de gaz : 70/10/20), CH₄/N₂O (par exemple, en ratio de débit de gaz : 80/20) ou HMDSO/N₂O/O₂ (par exemple, en ratio de débit de gaz : 80/10/10).

En outre, dans le cas de mélanges de gaz, les gaz peuvent être mélangés en amont des générateurs 34 soit par une alimentation sélective des générateurs 34. Par exemple, pour un mélange He/Ar (par exemple 80/20, en ratio de débit de gaz), on peut soit pré-mélanger les deux gaz avant arrivée dans le générateur 34, soit alimenter 80% des générateurs activés en ion d'hélium mono-chargé He⁺ et 20% des générateurs activés en ion d'argon mono-chargé Ar⁺. On peut également envisager d'alimenter les générateurs 34 en hélium, puis, de les alimenter en argon

### Exemple 3 : séquences successives de traitement avec des gaz différents

Egalement, il est possible de réaliser un traitement en séquence, chaque séquence utilisant un gaz différent avec des conditions spécifiques.

Par exemple, selon les séquences suivantes :

| | gaz précurseur | tension d'extraction | dose | temps de traitement |
|---|---|---|---|---|
| Séquence 1 | He | 30 KV | 6.10¹⁵ ions/cm² | 2s |
| Séquence 2 | N₂ | 20 kV | 10¹⁶ ions/cm² | 3s |
| Séquence 3 | I₂ | 5 kV | 10¹⁴ ions/cm² | 5s |

Il est également possible au lieu de traiter en séquence de réaliser ces traitements (par exemple les trois ci-dessus) simultanément mais en réalisant une répartition spatiale différente dans une matrice de générateurs de plasma.

## Revendications

1. Installation (10) de traitement d'une surface d'un objet (14), du type comprenant:
- une chambre à vide (12), dans laquelle l'objet (14) est destiné à être placé,
- des moyens de traitement (32) en communication avec la chambre à vide (12) de la surface de l'objet (14) comportant :
- des moyens de bombardement ionique comprenant un générateur de plasma (34), et
- des moyens de traitement par plasma comprenant un générateur de plasma (34),
**caractérisée en ce que** le générateur de plasma (34) est commun aux moyens de bombardement ionique et aux moyens de traitement par plasma.

2. Installation (10) selon la revendication 1, dans laquelle le générateur de plasma (34) regroupe différents éléments qui permettent de générer un plasma, que ce soit pour réaliser des traitements par plasma ou pour générer un plasma à partir duquel les ions vont être accélérés pour être ensuite implantés.

3. Installation (10) selon la revendication 1 ou 2, dans laquelle le générateur de plasma (34) permet d'obtenir une installation dans laquelle la surface d'un objet peut subir différents traitements de surface, impliquant la génération d'un plasma, sans l'utilisation de plusieurs générateurs dédiés chacun à un traitement particulier.

4. Installation (10) selon l'une quelconque des revendications précédentes, dans laquelle au moins un même générateur de plasma est apte à être utilisé indifféremment pour réaliser, en alternance, des traitements par plasma et des traitements par bombardement ionique.

5. Installation (10) selon l'une quelconque des revendications précédentes, dans laquelle le générateur de plasma (34) comprend les moyens de bombardement ioniques, ces moyens de bombardement ioniques comprenant:
- deux bornes (35A, 35B) reliées à des potentiels différents permettant de créer un plasma entre ces deux bornes,
- une électrode extractrice (36A) permettant de sélectionner les espèces que l'on désire bombarder, et
- au moins une électrode accélératrice (36B, 36C) disposée entre, d'une part, lesdites bornes (35A, 35B) et, d'autre part, l'objet (14) sur la surface duquel on souhaite bombarder les ions, l'électrode accélératrice permettant d'accélérer les espèces que l'on désire bombarder.

6. Installation (10) selon la revendication précédente, dans laquelle les moyens de traitement par plasma comprennent :
- un élément métallique positionné dans ladite chambre à vide (12) et relié à un potentiel de référence,
- une desdites bornes (35B) reliée aux parois du générateur de plasma (34) à un potentiel permettant de générer un plasma dans la chambre à vide (12).

7. Installation (10) selon la revendication précédente, comprenant des moyens d'injection de gaz (44) agencés de manière à pouvoir injecter un ou plusieurs gaz directement dans ladite chambre à vide (12).

8. Installation (10) selon la revendication 5, dans laquelle les moyens de traitement par plasma comprennent lesdites deux bornes (35A, 35B) reliées à des potentiels différents permettant de créer un plasma entre ces deux bornes.

9. Installation (10) selon l'une quelconque des revendications précédentes, dans laquelle le générateur de plasma (34) comprend des moyens d'injection de gaz (38, 40) aptes à injecter des gaz de nature différente, seuls ou en mélange.

10. Installation (10) selon l'une quelconque des revendications précédentes, dans laquelle le générateur de plasma (34) est de petites dimensions, c'est-à-dire que sa plus grande dimension est inférieure à 10 cm.

11. Installation (10) selon l'une quelconque des revendications précédentes, comprenant une pluralité de générateurs de plasma (34).

12. Installation (10) selon la revendication précédente, comprenant des moyens de contrôle (46) de chaque générateur (34) indépendamment de tout autre générateur (34).

13. Installation (10) selon la revendication précédente, dans laquelle les moyens de contrôle (46) comprennent, pour chaque générateur (34), des moyens d'activation/désactivation (48) du générateur (34).

14. Installation (10) selon l'une quelconque des revendications précédentes, comprenant des moyens d'isolement (50) du générateur de plasma (34) par rapport à la chambre à vide (12), ces moyens d'isolement (50) comprenant, par exemple, une porte.

15. Procédé de traitement de surface d'un objet (14) du type dans lequel on place l'objet (14) à traiter dans une chambre à vide (12) d'une installation (10) selon l'une quelconque des revendications précédentes.
